# EUROPEAN PATENT APPLICATION

(11) **EP 4 665 104 A1**
(43) Date of publication of application: **17.12.2025**
(21) Application number: 25181460.4
(22) Date of filing: 06.06.2025
(51) Int. Cl.: H05K 7/20

(54) **COOLING DEVICE FOR COOLING ELECTRONIC COMPONENTS AND ITS USE**

(30) Priority: 12.06.2024 DK PA202430315
(71) Applicant: Semikron Danfoss GmbH, 24941 Flensburg (DE)
(72) Inventor: Olesen, Klaus Kristen, 6430 Nordborg (DK)
(74) Representative: Medenwaldt, Robin

(57) **Abstract**

For efficient cooling of electronic components (3), in particular power electronics in an electric vehicle, the electronic components (3) are provided on an outer side of a first coolant chamber wall (2A) of a cooling device (1). The cooling device (1) has an inner coolant chamber (10) with an array of compartments (14) formed by first and second fins (13A, 13B) lateral to the flow direction (5). For flow through the compartments (14), the coolant flows between a pair of two fins (13A, 13B) that form compartment walls (20).

## Description

### FIELD OF THE INVENTION

The present invention relates to cooling device for cooling electronic components and use thereof, for example for an electric vehicle.

### BACKGROUND OF THE INVENTION

In electric vehicles, the available power for propulsion is regulated in modules that contain power converters, switches, and regulators, which are subject to heating and which must be cooled in order to avoid damage. Especially during accelerations, electric vehicles, EV, need power in excess of 100 kW, for example up to 500 kW as in popular EV models at the time of filing of this application, and although only a small percentage of this power is converted to heat in the electronic power control system, the heat created in the electronic system can be as much as several kW, and with a local power density of more than 500 W/cm², which is substantial. To give an impression of this power, it is put forward that this power density is more than what a kitchen cooking plate produces. This heat has to be removed efficiently from the electronics in order to prevent damage by overheating. Accordingly, cooling of the electronics is a serious issue in EVs.

This issue is discussed in detail in US11644253, disclosing a cooling module for a power converter. For efficient cooling, this disclosure suggests two opposite parallel thermally conducting walls for cooling electronics on the outer side of each of the walls. A flow field for coolant is provided inside the volume between the two walls. Each of the walls has on its inner side a plurality of parallel fins extending from the respective wall for forming the flow field. The two sets of fins are combined and arranged intertwined so that one fin from one of the walls is located between two fins from the opposite wall. The fins are shorter than the distance between the walls so that the flow field causes the coolant to flow between two fins to the one of the walls, then change direction at the wall and continues its flow into a space between a neighboring pair of fins to the opposite wall, where the coolant changes direction again, so as to continue flowing in a meander-shaped flow path through the coolant volume. The cooling fins are corrugated and form flow channels for providing low pressure drop and high flow speed, which increases the throughput of coolant through the cooling module.

Although, the considerations expressed in US11644253 appear as an improvement relatively to older prior art, it has a disadvantage of substantial high pressure drop if the number of fins is high, which is due to the fact that the coolant is changing directions into opposite flows for each further fin. Serpentine paths are disclosed in DE102017109890A1, EP1683404B1, US2012/0139096A1, US2021/0130002A1, US2022/0170706A1.

DE112022002737T5 discloses a cooling unit in which corrugated ribs are connecting two opposite walls, where the corrugated ribs are perforated for coolant flow through the ribs.

Despite the above-mentioned systems, which are disclosing various forms for advantages, there is a still an ongoing motivation to further improve cooling modules and there is still room for improvements and alternative configurations for efficient cooling of high power electronics, such as inverters and converters in vehicles.

### DESCRIPTION / SUMMARY OF THE INVENTION

It is therefore an objective of the invention to provide an improvement in the art. In particular, it is an objective to provide efficient cooling systems for electronics which are suitable for low-cost mass production, in particular in connection with electric vehicles. It is a further objective to provide a cooling device for cooling of electronics on a thermally conductive support plate in which the temperature distribution in the support plate is uniform. This objective and further advantages are achieved with a cooling device for cooling electronic components, its use, and method of operation, as described below.

For clarification of the invention described herein in view of the prior art described above, especially in view of US11644253, it must be explained here as an offset that the invention described herein takes a different approach to solve the problem of efficient cooling of electronics as compared to the principle disclosed in US11644253. By studying the meander path of the coolant through the channels formed by the corrugated fins in US11644253, it is understood that the smooth canal-forming fins involve reduced turbulence of the coolant, which bring about the low pressure drop and high flow speed that is aimed at in US11644253. However, a consequence of reduced turbulence is reduced mixing of the coolant inside the channels, which in turn implies a risk of the coolant becoming hot near the cooling fins but remaining cooler in the center of the channels, so that the capacity of the coolant is not fully exploited. In the invention presented herein, the solution follows a different approach with increased turbulence and mixing.

In short, for cooling of electronic components, for example power electronics in an electric vehicle, the electronic components are provided on an outer side of a first coolant chamber wall of a cooling device. The cooling device has an inner coolant chamber with an array of fins that form compartment walls between multiple compartments, which are lateral or approximately lateral to the flow direction. For flow through the compartment, the coolant crosses the fins, which creates turbulence in the compartments for better mixing of the coolant and increased thermal uptake.

Details are explained in the following.

The electronic components that are to be cooled are in thermal contact with an outer side of a thermally conducting first coolant chamber wall. For cooling purposes, the cooling device comprises a coolant chamber delimited by an inner side of the first coolant chamber wall and an inner side of an opposite second coolant chamber wall. The inner sides of the first and second coolant chamber walls are facing each other at an interdistance. Typically, for simplicity in production, the first and the second coolant chamber walls are planar and arranged parallel to each other with an interplanar distance. The coolant chamber is further delimited by a first and a second coolant chamber side wall.

The coolant, for example water, optionally containing glycol, flows through the coolant chamber along an average flow direction from a coolant inlet to a coolant outlet for cooling the first coolant chamber wall, and optionally also the second coolant chamber wall, in particular if the second coolant chamber wall also carries electronics on its outer side for cooling.

The coolant flow from the coolant inlet to the coolant outlet is along the inner sides of the first and second coolant chamber walls and the first and second coolant chamber side walls, which in common confine the coolant flow through the coolant chamber from one end to the opposite end.

The cooling device comprises a first array of multiple side-by-side placed, thermally conductive first fins, each of which is connected to the inner side of the first coolant chamber wall by a thermally conductive and sealing connection and has a first end that extends therefrom a first distance from the inner side of the first coolant chamber wall into the coolant chamber towards the second coolant chamber wall. The coolant chamber comprises as well a second array of multiple side-by-side placed second fins, each of which is sealingly connected to the inner side of the second coolant chamber wall and has a second end that extends a second distance from the inner side of the second coolant chamber wall into the coolant chamber towards the first coolant chamber wall. The term sealingly implies that it is liquid tight and no liquid passes through the connection at the respective coolant chamber wall.

Notice that the connection between the fins and the respective coolant chamber wall conducts heat away from the electronics through the coolant chamber wall and into the coolant. Typically, the coolant is a liquid.

Optionally, the device has only one coolant chamber wall that is provided with electronic components on its outer side, but it is also possible to provide electronic components on an outer side of the opposite second coolant chamber wall of the device. As the first coolant chamber wall carries electronics, it is made of a thermally conducting material as well as the first fins, for example metal, and the first fins are in thermally conductive connection with the first coolant chamber wall for removal of thermal energy from the electronics, through the first coolant chamber wall, and through the fins into the coolant. Similar conditions are valid for the second coolant chamber wall if it also carries electronics that have to be cooled. Otherwise, this is not necessary, and the second coolant chamber wall and the second fins are not necessarily made of a thermally conducting material.

Although, the coolant does not move linearly but with turbulence, there is an average flow direction for coolant through the coolant chamber from a coolant inlet to a coolant outlet for cooling the first coolant chamber wall.

In particular, the second fins are provided with recesses to accommodate end portions of the first fins. Alternatively, or in addition, the first fins are provided with recesses to accommodate end portions of the second fins. Typically, the recess depth in the recesses of the first and/or second fins is within 5-30% of the coolant chamber wall interdistance. For example, the recess depth is the same for all first fins, if the first fins have recesses. For example, the recess depth is the same for all second fins, if the second fins have recesses. If both the first fins and the second fins have recesses, the recess depth of the first fins is, optionally. not necessarily identical to the recess depth of the second fins.

Each of the recesses forms a crossing point where one of the first fins crosses one of the second fins. The crossing is defined in a projection plane parallel with the first coolant chamber wall, where the first and second fins are projected onto the projection plane. There are provided recesses so that each of the first fins crosses at least one the second fins at the recesses, and each of the second fins is crossing at least one the first fins at the recesses. For each of the first fins and each of the second fins, there are multiple crossing points. Additionally, pairs of a first fin and a second fins form canals between the recesses for flow of coolant from one compartment to a neighboring compartment, the compartments being lateral or largely lateral to the average flow direction and formed by neighboring fins.

If both the first fins and the second fins are made of a mechanically rigid material, especially a thermo-conductive metal, it is an advantage if the first fins and the second fins face each other with a gap in between. This eases restrictions for mechanical tolerance in fabrication. In no event, the distance of the gap would exceed 20%, for example be equal to or less than 10%, of the interdistance, and the gap would typically be smaller. For example, the gap is 0.1-0.5 mm.

For example, if the first fins have recesses, optionally, the first distance plus the second distance minus the recess depth of the first fins is less than the coolant chamber wall interdistance. As another example, if the second fins have recesses, optionally, the first distance plus the second distance minus the recess depth of the second fins is less than the coolant chamber wall interdistance, which results in a gap between the recesses and between the first and second fins.

When the fins do not meet but have a minor gap in between, the coolant will be pressed through the narrow gap and experience influence on its further flow direction behind the gap due to the lateral undulations of the fins.

However, it is also possible that the first fins have first recesses and the second fins have second recesses, and the first and second recesses face each other with a small gap in between. In this case, the first distance plus the second distance minus the first recess depth minus the second recess depth is less than the coolant chamber wall interdistance, which results in a gap between the recesses that face each other and between the first and second fins.

Notice that the first distance is the maximum distance by which the first fins extends from the first coolant chamber wall. Similarly, the second distance is the maximum distance by which the second fins extends from the second coolant chamber wall.

Alternatively, the first fins and the second fins meet, for example so that they touch each other in the recesses. This is advantageous in that this setup minimizes coolant to bypass the formed canals from one to the next compartment. which is useful for creating the turbulence and for guiding the coolant towards the first coolant chamber wall where cooling is crucial.

In order to make sure that the first fins and the second fins actually meet each in the recesses when the cooling device is assembled, while preventing overload on the contact area due to manufacturing tolerances where the sum of the lengths exceed the wall interdistance, the second fins optionally are made of a resilient material, for example rubber or other resilient polymer, for compression. For this purpose, when the first ends should meet recesses in the second fins or the second ends should meet recesses in the first fins, the sum of the first and second distance minus the depth of the recess is more than 100% of the coolant chamber wall interdistance when in a state prior to assembly and equal to 100% in assembled state due to compression of the resilient second fins.

The coolant will be directed upwards and downwards, respectively, by every second of the undulations. For example, first bend portions of the undulations, which are bend in an upstream direction, causes bending of the coolant into a first direction just behind the first bend. Second bend portions of the undulations, which are bend in a downstream direction, causes bending of the coolant in an opposite direction just in front of the second bend. The combination causes motion of the coolant in two opposite direction towards the two coolant chamber walls when entering the compartment behind such undulating fin, which results in vigilant turbulence of the coolant, mixing warmer and colder portions of the coolant and equalizing the temperature in a compartment. This, in turn, increases the cooling efficiency.

The recesses provide a number of advantages. Due to the recesses, the fins partly overlap and, thus, can be designed with a larger surface than if the first fins meet the second fins edge-to-edge. A high surface area is advantageous for high cooling power. Further, due to the recesses, the first and second coolant chamber walls are closer to each other due to the partial overlap of first and second the fins than if the first fins and the second fins with the same surface area would face each other or meet edge-to-edge. Also this increases cooling power, especially, because the coolant is forced towards the first cooling chamber wall to a greater degree than if the coolant chamber walls have a comparatively greater distance. In particular, the configuration with the overlapping fins provides a better direction for the coolant towards the walls so that a thorough contact of the coolant with the first coolant chamber wall is achieved as well as vigorous mixing of the coolant in the various compartments. Accordingly, a simple configuration adjustment by the recesses brings about multiple advantages and an increased cooling efficiency.

The array of first fins and the array of second fins forms an array of compartments. Optionally, the first and second arrays of fins pairwise form an array of compartment walls, each of which is separating two neighboring of multiple compartments.

Optionally, the arrays of compartments are delimited by the first and second coolant chamber wall, the first and second coolant chamber side wall and the first and second fins.

The first and second fins and compartments are oriented perpendicular to the average flow direction. Alternatively, first and second fins and compartment are oriented almost perpendicular to the average flow direction. In more detail, each of the first fins and the second fins, and, correspondingly, the compartments, extend from the first to the second coolant chamber side wall and are oriented within the range of 70-110 degrees, for example within the range of 80-100 degrees, or even within the range of 85 to 95 degrees, relatively to the average flow direction. In any case, the coolant has to cross all first fins, second fins, and compartments during flow of the coolant through the coolant chamber.

The first distance by which the first fins extend from the first coolant chamber wall and second distance by which second fins extend from the second coolant chamber wall are optionally identical but need not be so. However, the first distance, when measured in a perpendicular direction from the inner side of the first coolant chamber wall, and the second distance, when measured in a perpendicular direction from the inner side of the second coolant chamber wall, is at least 20%, for example at least 30%, of the coolant chamber wall interdistance.

The first fins or the second fins or both have an undulating shape. The undulation causes turbulence in the coolant when it crosses the laterally undulating compartment walls.

The undulating shape of the first fins has a first undulation wavelength, and the undulating shape of the second fins has a second undulation wavelength. Typically, the first undulation wavelength is identical to the second undulation wavelength but need not be so.

In particular, each combination of one of the first fins and one of the second fins forms multiple first and second canals between the crossing points, the canals connection neighboring compartments. This is achieved by the combination of first and second fins, where the first fins or the second fins or both have an undulating shape. For example, both have an undulating shape and the undulations of the first fins are mirrored relatively to the undulation of the second fins, the mirroring being in a plane lateral to the first cooling chamber wall and extending through crossing points of a fin. Optionally, the lengths of the fins are different, but the undulations are identical apart from the mirrored shape.

Optionally, as an alternative, the first fins are undulating and the second fins are straight, or vice versa.

For example, for pairs of first fins and second fins, a first canal is formed by a first portion of the first fin and a first portion of the corresponding second fin, and a second canal is formed by a second portion of the first fin and a second portion of the second fin, the second portions being different from the first portions. Such first and second canals are arranged alternatingly along the compartment walls due to the undulating shape with one of the first canals between two of the second canals and one of the second canals between two of the first canals. Each first canal has a first coolant flow direction and each second canal a second, opposite coolant flow direction from one compartment through the compartment wall into a subsequent compartment along the average flow direction. The first flow directions is towards the first coolant chamber wall but not towards the second coolant chamber wall and the second flow directions is towards the second coolant chamber wall but not the first coolant chamber wall.

In comparison to the aforementioned US11644253, it is emphasized that the coolant in US11644253 flows unidirectional along one side of a wall and then shift direction to flow in opposite direction on the opposite side of the wall, which is typical in meander-flow. This implies that the coolant enters a compartment in only one direction and moves in an almost laminar flow along the undulated fins inside the compartment. In the invention, the coolant flows from one compartment to the subsequent compartment across the undulated fins and is deflected by the undulated fin into two opposite directions simultaneously which creates turbulence inside the subsequent compartment.

In the cooling device described herein, the flow crosses all undulating fins largely laterally, as the average flow through the cooling chamber is largely laterally to the arrays of fins.

Each of the first fins and/or the second fins has an alternating wave-form that is undulating about a line parallel with the first coolant chamber wall so as to comprise a first set of bends on a first side of the line and a second set of bends on a second, opposite side of the line. The first set of bends are directed upstream and the second set of bends are directed downstream. For example, the line is perpendicular to the average flow direction. Alternatively, the line is inclined and deviates in the range of up to 10 degrees, or even up to 20 degrees, from the perpendicular direction, the latter being equivalent to an angle in the range of 70-110 degrees relatively to the average coolant flow direction.

In some embodiments, which eases production, the second fins have undulations identical to the first fins, but are rotated 180 degrees about a line perpendicular through the first coolant chamber wall so as to provide the undulations of the second fins as mirrored relatively to the first fins and relatively to a plane that is perpendicular to the first coolant chamber wall and extends through the crossing points of a second fin. In such embodiments, apart from the recesses, the first coolant chamber wall with its first fins is similar to the second coolant chamber wall with its second fins.

Optionally, the first fins are perpendicular to the first coolant chamber plate. Optionally, alternatively or in addition, the second fins are perpendicular to the second coolant chamber plate.

Optionally, the first and the second coolant chamber walls are parallel.

Although, the fins can be mounted onto the inner side of the respective coolant chamber wall, it can be advantageous if the first fins are integral with the first coolant chamber wall. For example, the first fins and the first coolant chamber wall are formed out of a single piece of material. An option in this respect is a single forged metal block. Metal forging under high pressure is a fast production method, and due to the first coolant chamber wall and first fins being a single metal piece, where the metal is thermally conducting, good thermal conductivity is provided from the coolant chamber wall through the fins to the coolant. As an alternative to metal forging, molding of metals or other thermally conducting materials, such as thermally conducting polymers, is useful or sintering of thermally conductive ceramics

Optionally, the cooling device comprises one or more cooling modules in a housing, typically, also comprising a manifold for the distribution of coolant into and out of the modules. The cooling device has a coolant inlet and a coolant outlet and a coolant flow path in an inner volume of the device and through a coolant chamber for each of the modules, from the coolant inlet to the coolant outlet. Electronics are provided on each module wall for efficient cooling, as the electronics have thermal contact to the thermally conducting wall, for transfer of thermal energy from the electronic components through the module wall and to the circulating coolant inside the coolant chamber of the module. Each module wall is formed similar to the first coolant chamber wall described above with its fins reaching into a coolant chamber inside the housing. Optionally the housing forms the second coolant chamber wall for each of the modules.

The term undulating wave-form is used for a structure that is repetitive alternating in a plane, for example a structure with edges, such as a zigzag-shaped structure, or a smoothly undulating structure, such as a sine-shaped structure.

Typically, all first fins are shaped mutually identical and arranged mutually equidistant with a first fin distance when measured along the average flow paths, and all second fins are shaped mutually identical and arranged mutually equidistant with a second fin distance when measured along the average flow paths. The first fin distance and the second fin distance are optionally identical but can also be different.

The coolant chamber encloses at least three, but typically more than three first and second fins.

Typically, the compartment walls comprises at least three first canals and three second canals.

Useful dimensions have been found in the first fins extending a first distance of 2-8 mm from the first coolant chamber wall. Similarly, it has been found useful if the second fins extend a second distance of 2-8 mm from the second coolant chamber wall.

Advantageously, the ribs are non-perforated, in contrast to DE112022002737T5. In other words, the ribs do not contain perforations through which the coolant would be able to flow, but the coolant is forced to flow around the ribs in order to advance.

The cooling device is useful in particular for cooling power electronics, e.g. in an electric vehicle (EV) or a wind turbine, for example cooling power modules, converters and/or inverters.

Optional dimensions of the cooling module are 50-250mm x 50-250mm x 5-30mm for automotive applications.

For example, dimensions of a cooling device, when used for a personal electric vehicle, are approximately 200 mm x 60 mm x 15 mm.

For renewable energy applications, such as the power electronics in wind turbines where several MW are processed or off-road electric vehicles for example mining the cooling device dimension will be on the order of 200-800mm x 200-800mm x 20-80mm.

Although, the device is particularly useful for vehicles, it is of more general character and can also be advantageous for use in an industrial machine for cooling electronic components. Another advantageous use is in a wind turbine for cooling electronic components. It is also applicable in other applications where high-power electronic components require liquid cooling, for example solar inverters.

### SHORT DESCRIPTION OF THE DRAWINGS

The invention will be explained in more detail with reference to the drawing, where
FIG. 1 illustrates a cooling device of an embodiment in a perspective view;
FIG. 2 is a perspective view of first fins on the first coolant chamber wall of an embodiment;
FIG. 3 is an overlay image of undulating first fins and straight second fins of an embodiment;
FIG. 4A illustrates first fins in an exemplary embodiment;
FIG. 4B illustrates second fins in an exemplary embodiment;
FIG. 4C is a side projection of the coolant chamber of the embodiment illustrated in
FIG. 4A and 4B;

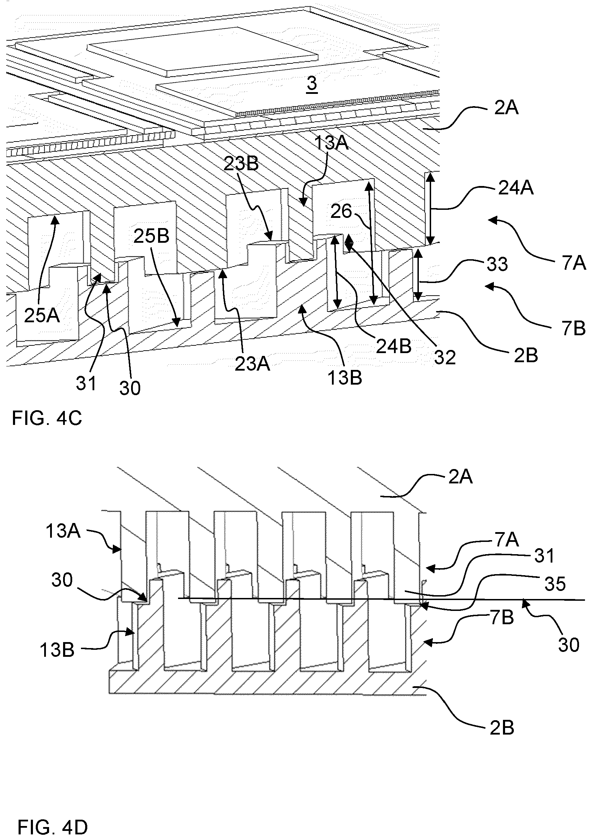

FIG. 4D is an enlarged portion of the side projection of FIG. 4C;

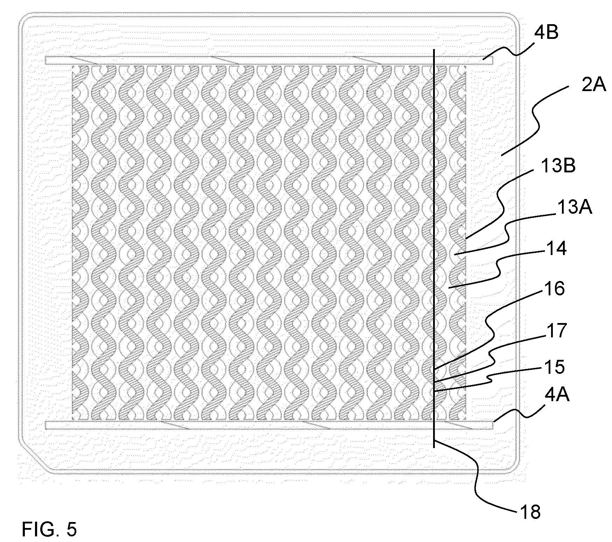

FIG. 5 illustrates an embodiment with two arrays of undulating fins that are rotated 180 degrees relatively to each other;

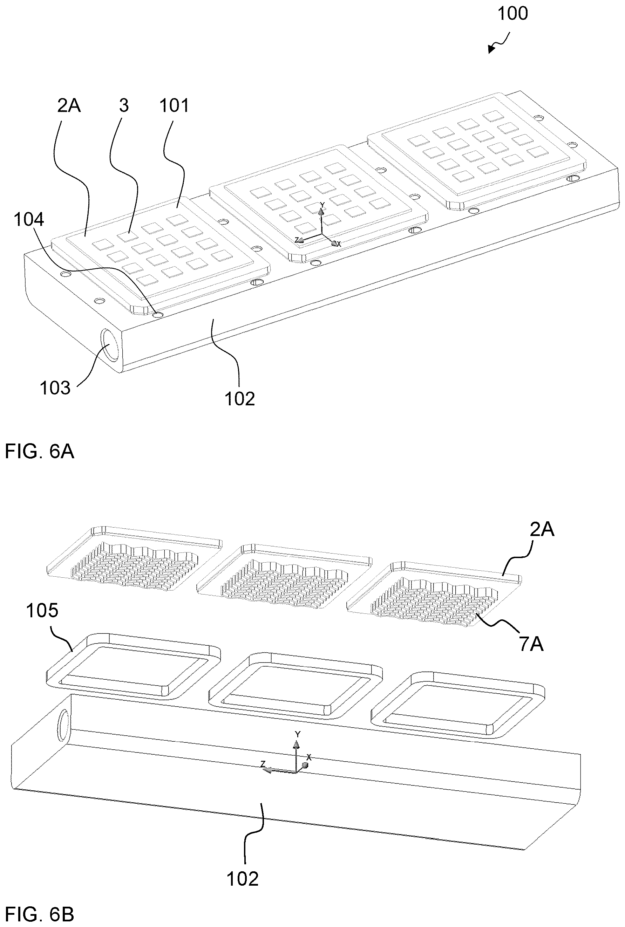

FIG. 6A illustrates an array of coolant modules in perspective view;
FIG. 6B illustrates the array of FIG. 6A in an exploded view.

### DETAILED DESCRIPTION / PREFERRED EMBODIMENT

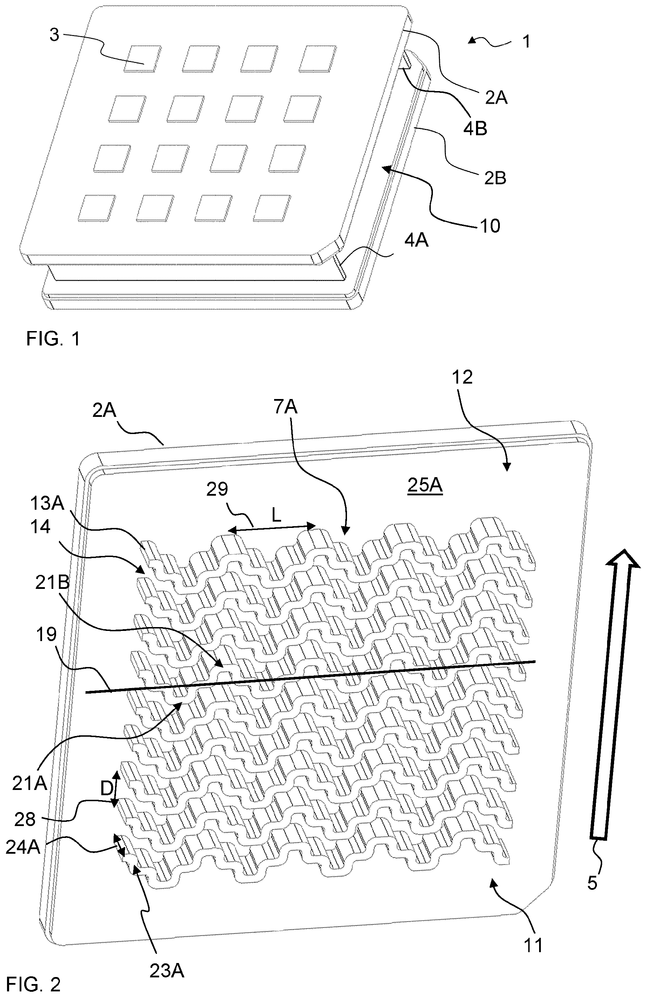

Figure 1 is a perspective view of a cooling device 1 for cooling electronic components 3 on at least one of its outer surfaces, optionally on both surfaces. The cooling device 1 has a sandwich structure of a first coolant chamber wall 2A and a second coolant chamber wall 2B, sandwiching a coolant chamber 10 in between, which is further delimited by two side walls 4A, 4B on opposite sides of the coolant chamber 10.

Important is that the first coolant chamber wall 2A that is used for cooling of the electronics 3 is thermally conductive in order for the first coolant chamber wall 2A to take up thermal energy from the electronics 3 on the outer side of the first coolant chamber wall 2A and transfer the thermal energy to the coolant that is flowing inside the coolant volume 10 along the inner side of the first coolant chamber wall 2A. If there are electronics 3 provided on the outer side of the second coolant chamber wall 2B, this should be thermally conductive as well.

FIG. 2 shows an enlarged view of an exemplary embodiment of the first coolant chamber wall 2A. The view is towards the inner side 25A of the first coolant chamber wall 2A, which faces the coolant chamber 10, which is opposite to the side on which the electronics 3 are mounted. A first flow structure 7A is provided on the inner side 25A of the first coolant chamber wall 2A as part of a flow field that is directing the flow of coolant through the coolant chamber 10. The first flow structure 7A comprises multiple identical undulating first fins 13A with identical flow compartments 14 in between pairs of the undulating first fins 13A. The first fins 13A are arranged parallel and equidistant with a fin-distance D indicated by arrow 28. The undulations are periodic with a constant wavelength L, as indicated by the arrow 29. An arrow 5 indicates the average flow direction. It is observed that the undulating first fins 13A and, correspondingly, the first flow compartments 14 are arranged perpendicular to the average flow directions 5. In more detail, the undulating first fins 13A and the resulting compartments 14 have average longitudinal direction along a line 19 that is perpendicular to the average flow direction 5 of the coolant.

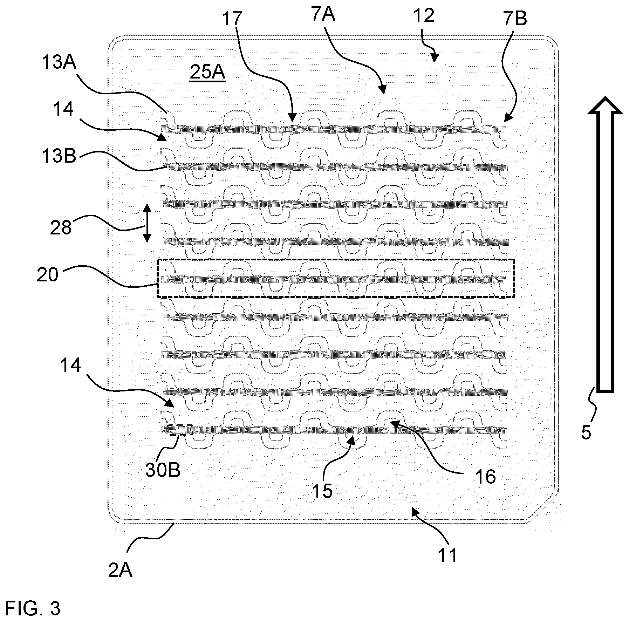

FIG. 3 illustrates an embodiment of a flow field in the coolant chamber 10. The first flow structure 7A on the inner side 25A of the first coolant chamber wall 2A is as illustrated in FIG. 2.

Between the second coolant chamber wall 2B and the first flow structure 7A, there is provided a second flow structure 7B, which comprises a plurality of straight, parallel second fins 13B. Similar to the equidistant undulating first fins 13A and the flow compartment 14 in between the undulating first fins 13A, also the straight, parallel second fins 13B are arranged equidistant with the same fin-distance 28 and perpendicular to the average flow direction 5. As seen in FIG. 3, each undulating first fin 13A is undulating symmetrically to opposite sides of the corresponding straight, parallel second fin 13B.

Accordingly, each flow compartment 14 is delimited by two neighboring undulating first fins 13A and that portion of the first coolant chamber wall 2A that is in between these two neighboring undulating first fins 13A. Further delimitation is provided by two neighboring straight, parallel second fins 13B and that portion of the second coolant chamber wall 2B that is in between these two neighboring straight, parallel second fins 13B. Each pair of one first fin 13A and one second fin 13B forms a flow-guiding wall 20 of the compartments 14.

The first fins 13A and, optionally, also the second fins 13B are made of a thermally conducting material and in thermally conductive connection with the corresponding coolant chamber wall 2A, 2B that is cooling electronics. Embodiments where both the first fins 13A and the second fins 13B are thermally conductive are especially useful if both the first and the second coolant chamber wall 2A, 2B carry electronics to be cooled on their outer sides.

For example, the first flow structure 7A is integral with the first coolant chamber wall 2A or attached to it, for example glued, welded or brazed to the first coolant chamber wall 2A. For example, the second flow structure 7B is integral with the second coolant chamber wall 2B or attached to it, for example glued, welded or brazed to the second coolant chamber wall 2B. The first flow structure 7A is not fastened to the second flow structure 7B, but the two flow structures 7A and 7B are brought together during assembly to form the final flow field.

The term "attached to" refers to the two structures being provided separately and then joined, for example by gluing, welding or brazing. The term "integral with" refers to the corresponding structures being made out of a single piece, for example by milling or casting or sintering, optionally using heat-conductive polymers or ceramics. A further possible production method that can be used for producing the flow structures 7A, 7B as integral with the corresponding coolant chamber walls 2A, 2B, is impact extrusion, also called forging, in which a stamp with a template matrix by high pressure impact deforms a metal block into the desired shape. Another possible production method is three dimensional printing.

As an example, in the illustrated embodiment in FIG. 3, the first flow structure 7A is integral with the first coolant chamber wall 2A, wherein the undulating first fins 13A and the first coolant chamber wall 2A are made of a single piece of material. As a further option, the second flow structure 7B is integral with the second coolant chamber wall 2B, wherein the straight second fins 13B and the second coolant chamber wall 2B are made of a single piece of material. These two options can be combined.

With reference to FIG. 3, the undulating portions of the first fins 13A on opposite sides of the second fin 13B form first canals 15 and second canals 16 which connect neighboring compartment 14. These canals 15, 16 provide flow from one compartment to its subsequent compartment 14 in opposite directions, one direction, which is towards the first coolant chamber wall 2A, and the opposite direction, which is towards the second coolant chamber wall 2B. As the straight second fin 13B obstructs a straight flow of the coolant from the inlet compartment 11 and in the average flow direction 5, a first portion of the coolant is forced to flow from the inlet compartment 11 into and through the array of first canals 15 and into the subsequent compartment 14 in the direction towards the inner side 25A of first coolant chamber wall 2A, while a second portion of the coolant is forced to flow from the inlet compartment 11 into and through the array of second canals 16 and into the subsequent compartment 14 in the direction towards the second coolant chamber wall 2B. Similarly, the flow of the coolant continues into and through all of the subsequent compartments 14 until reaching the outlet compartment 12. This flow in opposite directions into the compartments 14, and likewise out of the compartments 14, is important, as it creates turbulence and heavy mixing in the coolant, so that the temperature of the coolant in a compartment 14 is largely constant throughout the compartment 14 and, thus, optimized for maximum uptake of thermal energy from the first fins 13A and the second fins 13B. Highly important is the aspect that the mixing leads to an even temperature profile on the coolant chamber walls, which is useful for proper functioning of the electronics.

Optionally, as an alternative, the second fins 13B have undulations identical to the first fins 13A and, in an assembled state of the coolant chamber 10, are rotated 180 degrees about a line perpendicular through the first coolant chamber wall 2A.

As an alternative, the undulating fins 13A, 13B may have different shapes for example a zig zag-shaped structure with rounded or sharp edges.

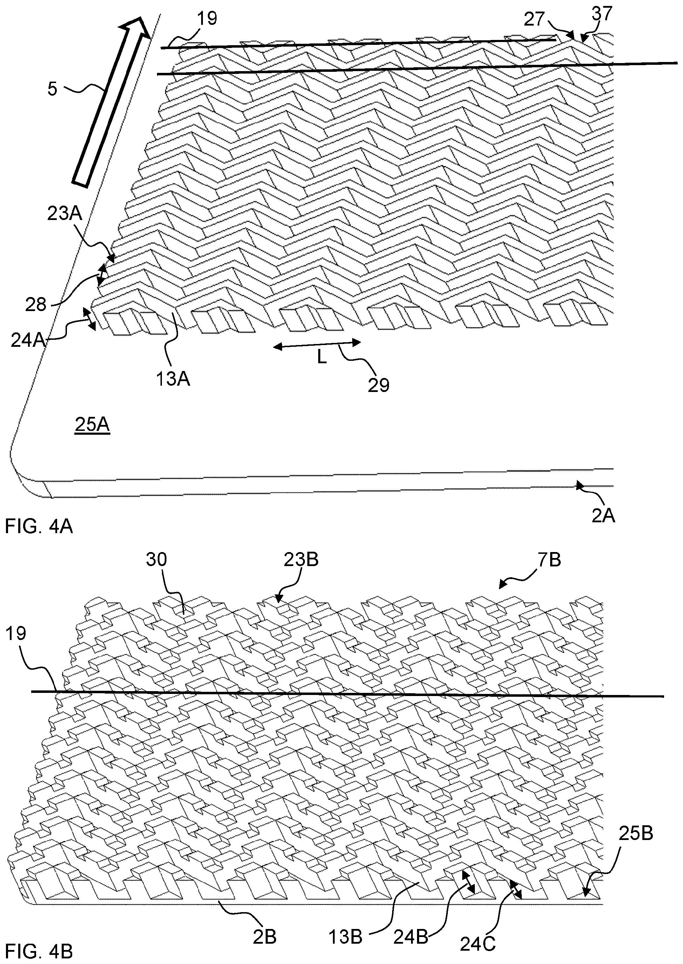

FIG. 4A, 4B, 4C and 4D, illustrates an alternative embodiment in which the first fins 13A on the first coolant chamber wall 2A have a zig-zag form. In more mathematical terms, this form is defined as skew polygon or skew apeirogon with vertices 27 alternating between two parallel lines 19. The zig zag shape has straight sections 37 between the vertices 27.

As illustrated in FIG. 4A, the first fins 13A have first ends 23A at a first distance 24A from the inner side 25A of the first coolant chamber wall 2A.

As illustrated in FIG. 4B, the second fins 13B have second ends 23B at a second distance 24B from the from the inner side 25B of second coolant chamber wall 2B. The second fins 13B have an overall similar zig zag shape as the first fins 13A. Although, the first fins 13A and the second fins 13B have similar overall zig zag shape, the second fins 13B are different from the first fins 13A in that they are provided with recesses 30 for accommodating end portions 31 of the first fins 13A when assembled.

In the assembled state, the second flow structure 7B with the second fins 7B is rotated 180 degrees relatively to the first flow structure 7A with the fins 13A about a line perpendicular to the first coolant chamber wall 2A and extending through a recess 30 so as to provide the second fins 13B with undulations that are mirrored relatively to the undulations of the first fins 13A, where the mirroring is relatively to a plane perpendicular to the first coolant chamber wall 2A and extending along the fins 13A, 13B through recesses 30 in the second fin 13B.

As illustrated in FIG. 4C, the recesses 30 in the second fins 13B have a recess depth 32 as measured from the second ends 23B. As illustrated in FIG. 4C, and in greater enlargement in FIG. 4D, the recesses 30 in the second fins 13B are arranged and positioned such that they accommodate end portions 31 of the first fins 13A in the recesses 30 when the first flow structure 7A of the first coolant chamber wall 2A and the second flow structure 7B of the second coolant chamber wall 2B are combined into a coolant device, for example as illustrated in FIG. 1.

Now, reference is made to FIG. 1 in combination with FIG. 4C. In embodiments, where the side walls 4A, 4B define the interdistance 26 between first coolant chamber wall 2A and the second coolant chamber wall 4B, it is advantageous if the first fins 13A and the second fins 13B do not meet but have a small gap 35 in between, as this allows larger production tolerances and prevents assembly problems due to surpassed production tolerances. In particular, it is detrimental for the assembly if the first distance 24A of a first fins 13A plus the distance 33 of the recess 31 from the inner side 25B of the second coolant chamber wall 2B happens to slightly exceed the chamber wall interdistance 26.

As an alternative, the second fins 13B are resilient for compression so that the second fins 13B are compressed slightly during assembly. In this case, the first distance 24A of a first fins 13A plus the distance 33 of the recess 31 from the inner side 25B of the second coolant chamber wall 2B slightly exceeds the chamber wall interdistance 26 when in a state prior to assembly and equal to 100% in assembled state due to compression of the resilient second fins 13B by the assembly.

Although, the above example has been illustrated with the second fins 13B being provided with recesses 30 that are accommodating end portions 31 of the first fins 13A, it is equally possible to provide the first fins 13A with recesses that accommodate end portions of the second fins 13B. As a further alternative, it is possible to provide first fins 13A with recesses and also the second fins 13B with recesses, each of which accommodate end portions of the opposite fins.

Having explained the principles of the accommodation of the end portions 31 in recesses 30 with reference to FIG. 4A-D, reference is now made to FIG. 3 for which similar principles are valid. The first fins 13A, which are undulating, are provided with recesses 30, one of them emphasized in FIG. 3 with a stippled rectangle 30B, for accommodating end portions of the straight second fins 13B. Alternatively, the straight second fins 13B are provided with corresponding recesses for accommodating end portions of the first fins 13A. The principles, as illustrated in FIG. 4C apply equally well in these embodiments.

As alternatives to the shown embodiments, the undulating fins 13A, 13B may have different shapes, for example a zig zag-shaped structure with rounded edges or even smoothly undulating structure, such as a sine-shaped structure, for example as illustrated in FIG. 5 in a top view.

Recesses are provided at the crossing points 17 between the first fins 13A and the second fins 13B. The first fins 13A and the second fins 13B, in combination form canals 15, 16 between the crossing points 17, the canals connecting neighboring compartments 14.

Also indicated in FIG. 5 is a plane 18 that is perpendicular to the first coolant chamber wall 2A and parallel with an average direction of the undulating first fins 13A. The undulations of the second fins 13B are mirror images of the undulations of the first fins 13A. For example, the first and the second fins 13A, 13B are identical, apart from the recesses 30 in the first fins 13A or in the second fins 13B, unless both the first fins 13A and the second fins 13B are both provided with recesses 30.

The flow speed of the coolant through the coolant chamber 10 is dependent on various parameters, such as periodic wavelength 29 of the undulating fin, amplitude of the undulating fin, and distance 28 from one fin to the neighboring fin in the array of fins as measured in the same direction as measuring the amplitude, as well as the wall thickness of the fin, as the latter determines the accessible canal width through which the coolant can flow.

As an example, a useful wall thickness is in the range of 0.3-2 mm, rather 0.6-1.6 mm.

In particular, the gap 35 should be no more than 15%, rather no more than 10%, of the coolant chamber wall interdistance 26. Typically, it will be less, though, corresponding to needed production tolerances, for example in the range of 0.1-0.5 mm.

FIG. 6A in perspective view and FIG. 6B in exploded view illustrate a cooling device 100 with an array of cooling modules 101 mounted inside a manifold housing 102. Each of the cooling modules 101 is to a large extent similar to the cooling device 1 of FIG. 1. It comprises a first coolant chamber wall 2A, similar to the first coolant chamber wall 2A in FIG. 1 but does not comprise a different second coolant chamber wall 2B, which in this embodiment, instead, is substituted part of the manifold housing 102. The first coolant chamber wall 2A, similar to the first coolant chamber wall 2A in FIG. 1, comprises a first flow structure 7A adjacent to the first coolant chamber wall 2A, for example attached to or integral with the first coolant chamber wall 2A. However, the second flow structure 7B, which is adjacent the opposite side of the separation wall 5, relatively to the first flow structure 7A, is provided inside the housing 102, for example inserted into the housing or integral with the housing 102. For example the second flow structure 7B with straight or undulated second fins 13B have recesses, as explained in connection with FIG. 3. A gasket 105 seals between the first coolant chamber wall 2A and the housing 102. From the inlet 103, coolant flows into the various coolant chambers and along the flow fields defined by the flow structures 7A, 7B and leaving the manifold 102 through coolant outlet 104.

## Claims

1. A cooling device (1, 100) for cooling electronic components (3) that are in thermal contact with an outer side of a thermally conducting first coolant chamber wall (2A);
wherein the cooling device (1, 100) comprises a coolant chamber (10) delimited by an inner side (25A) of the first coolant chamber wall (2A) and an inner side (25B) of an opposite, second coolant chamber wall (2B) and a first and second coolant chamber side wall (4A, 4B), wherein an average flow direction (5) is provided through the coolant chamber (10) for flow of coolant from a coolant inlet (103) to a coolant outlet (104) along the inner sides (25A, 25B) of the first and second coolant chamber walls (2A, 2B) and the first and second coolant chamber side walls (4A, 4B) for cooling the first coolant chamber wall (2A), wherein the inner side (25A) of the first coolant chamber walls (2A) and the inner side (25B) of the second coolant chamber wall (2B) are spaced by a coolant chamber wall interdistance (26);
wherein the cooling device (1) comprises a first array (7A) of multiple, side-by-side placed, thermally conducting first fins (13A), each of which is connected to the inner side (25A) of the first coolant chamber wall (2A) by a thermally conductive and sealing connection and has a first end (23A) that extends a first distance (24A) from the inner side of the first coolant chamber wall (2A) into the coolant chamber (10) towards the second coolant chamber wall (2B), and wherein the cooling device (1) comprises a second array (7B) of multiple side-by-side placed second fins (13B), each of which is sealingly connected to the inner side (25B) of the second coolant chamber wall (2B) and has a second end (23B) that extends a second distance (24B) from the inner side (25B) of the second coolant chamber wall (2B) into the coolant chamber (10) towards the first coolant chamber wall (2A);
wherein the first distance (24A) of each the first fins (13A), when measured in a perpendicular direction from the inner side (25A) of the first coolant chamber wall (2A), and the second distance (24B) of each of the second fins (13B), when measured in a perpendicular direction from the inner side (25B) of the second coolant chamber wall (2B), are at least 20% of the coolant chamber wall interdistance (26);
wherein the first fins (13A) or the second fins (13B) or both have an undulating shape;
wherein the first and second fins (13A, 13B) form compartments (14) located in between neighboring first and second fins (13A, 13B);
wherein each of the first and second fins (13A, 13B) extends from the first to the second coolant chamber side wall (4A, 4B) and is oriented within the range of 70-110 degrees relatively to the average flow direction (5) in order for the coolant to cross all first and second fins (13A, 13B) and all compartments (14) during flow of the coolant through the coolant chamber (10);
wherein the first fins (13A) or the second fins (13B) or both are provided with recesses (30) that are accommodating end portions (31) of the second fins (13) or first fins (13A), respectively, each of the recesses (30) having a recess depth (32), wherein the recesses (30) forms crossing points (17) where one of the first fins (13A) crosses one of the second fins (13B) in a plane parallel with the first coolant chamber wall (2A), wherein each of the first fins (13A) is crossing at least one of the second fins (13B) at the recesses (30) and each of the second fins (13B) is crossing at least one of the first fins (13A) at the recesses (30).

2. The cooling device according to claim 1, wherein the first fins (13A) and the second fins (13b) face each other with a gap (35) in between.

3. The cooling device according to claim 2, wherein the gap is 0.1-0.5 mm.

4. The cooling device according to claim 2 or 3, wherein the first distance (25A) plus the second distance (25B) minus the recess depth (32) is less than the coolant chamber wall interdistance (26).

5. The cooling device according to claim 1, wherein the second fins (13B) are resilient for compression, and wherein the first distance (25A) plus the second distance (25B) minus the recess depth (32) is more than 100% of the coolant chamber wall interdistance (26) when in a state prior to assembly and equal to 100% in assembled state due to compression of the resilient second fins (13B) by assembly.

6. The cooling device according to any preceding claim, wherein each pair of one of the first fins (13A) and one of the second fins (13B) forms canals (15, 16) between the recesses (30) for flow of coolant from one of the compartments (14) to a neighboring of the compartments (14).

7. The cooling device according to any preceding claim, wherein the recess depth (32) is 5-30% of the coolant chamber wall interdistance (26).

8. The cooling device according to any preceding claim, wherein the first fins (13A) are spaced equidistant with a first distance (D, 28) or wherein the second fins (13B) are spaced equidistant, or both.

9. The cooling device according to any preceding claim, wherein both the first fins (13A) and the second fins (13B) have an undulating shape.

10. The cooling device according to claim 9, wherein the first fins (13A) have undulations that are mirrored relatively to undulations of the second fins (13B) in a plane (18) that is perpendicular to the first coolant chamber wall (2A) and extending through crossing points (17).

11. The cooling device according to any preceding claim, wherein the first and second coolant chamber walls (2A, 2B) are parallel, wherein the first and second fins (13A, 13B) extend perpendicular from the coolant chamber walls (2A, 2B), and wherein the first and second ends (23A, 23B) face each other or meet along a plane (30) parallel to the first and second coolant chamber wall (2A, 2B).

12. The cooling device according to any preceding claim, wherein each of the first fins (13A) faces or meets only one of the second fins (13B).

13. The cooling device according to any preceding claim, wherein the first distance (24A) is identical for all first fins (13A) and wherein the second distance (24B) is identical for all second fins (13B).

14. The cooling device according to any preceding claim, wherein first fins (13A) and the second fins (13B) are non-perforated.

15. Use of a cooling device according to anyone of the preceding claims in an electrical vehicle for cooling electronic components (3) used for power regulation of electrical propulsion motors.
